(19) Europäisches Patentamt
European Patent Office
Office européen des brevets

(11) **EP 4 521 445 A2**

(12) **EUROPEAN PATENT APPLICATION**

(43) Date of publication:
**12.03.2025 Bulletin 2025/11**

(51) International Patent Classification (IPC):
*H01J 37/20* (2006.01)    *H01J 37/28* (2006.01)
*H01J 37/26* (2006.01)    *H01J 37/244* (2006.01)
*H01J 37/22* (2006.01)

(21) Application number: 24186098.0

(22) Date of filing: **02.07.2024**

(52) Cooperative Patent Classification (CPC):
**H01J 37/28; H01J 37/20; H01J 37/222;
H01J 37/244; H01J 37/265**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.07.2023 JP 2023117224**

(71) Applicant: JEOL Ltd.
**Akishima, Tokyo 196-8558 (JP)**

(72) Inventors:
• **ABE, Akira**
  **Tokyo, 196-8558 (JP)**
• **HATTORI, Taku**
  **Tokyo, 196-8558 (JP)**
• **MIYAHARA, Takenori**
  **Tokyo, 196-8558 (JP)**

(74) Representative: **Boult Wade Tennant LLP**
**Salisbury Square House
8 Salisbury Square
London EC4Y 8AP (GB)**

(54) **CHARGED PARTICLE BEAM APPARATUS AND CAMERA IMAGE DISPLAYING METHOD**

(57)    During an ascending process of a specimen unit (30), a camera image including a height guide is displayed. A display magnification controller (52) increases a display magnification of the camera image in response to a representative height of the specimen unit (30) having reached a magnification changing height. A protrusion amount computing unit (55) computes a protrusion amount of a specimen (32) from a specimen holder (31) based on a height of the specimen holder (31) at the time of accepting registration operation.

FIG. 1

EP 4 521 445 A2

**Description**

TECHNICAL FIELD

The present disclosure relates to a charged particle beam apparatus and a camera image displaying method, and more particularly to a charged particle beam apparatus including a camera that takes an image of the interior of a specimen chamber.

BACKGROUND

A charged particle beam apparatus irradiates a specimen with a charged particle beam for observation or processing, for example, of the specimen. The charged particle beam may be an electron beam or an ion beam, for example. A scanning electron microscope (SEM), which is a typical charged particle beam apparatus, will be described below.

A scanning electron microscope includes a specimen chamber accommodating a movable stage or a specimen stage. A specimen holder on which a specimen is placed is to be mounted onto the movable stage. Hereinafter, the specimen and the specimen holder will be collectively expressed as a specimen unit. The movable stage is a mechanism that changes the position and attitude of the specimen unit.

Prior to observation of a specimen, the position and attitude of the specimen unit are adjusted. Specifically, an observation site of the specimen is defined on an optical axis. For high resolution observation, the observation site is brought close to the objective lens; the specimen unit is therefore lifted upward.

A scanning electron microscope includes several means to avoid collision of the specimen unit with a structure such as an objective lens. A typical means among these is designed to restrict the movement of the specimen unit having reached a no-entry space that is defined in the vicinity of a surface of the structure.

However, a collision of the specimen unit with the structure within the specimen chamber may occur in the operation state of the several collision avoiding means described above, due to various factors, including, for example, erroneous setting of a protrusion amount of the specimen. Even when there is no possibility of such a collision, confirmation of the state of the specimen, including the position and the attitude, for example, is required prior to observation of the specimen. A scanning electron microscope therefore includes a camera, specifically an optical camera, which takes an image of the interior of the specimen chamber. During the process of adjusting the position and attitude of the specimen unit, a camera image, which is a real-time image or a live image, taken by the camera is displayed.

In particular, during an ascending process for moving the specimen unit close to the objective lens, a user references to the camera image. At this time, a small display magnification that is set for displaying the camera image would make it difficult to correctly specify the spatial relationship between the structure within the specimen chamber and the specimen unit. This may cause a delay in determination to stop the ascending movement, due to a delay in recognition of approach or collision of the specimen unit with respect to the structure within the specimen chamber.

A housing enclosing the specimen chamber and the structure within the specimen chamber are typically made of glossy metal. The specimen holder is also normally made of glossy metal. This makes the camera image showing the interior of the specimen chamber likely to have brightness or halation over the entire image. In such a state, there is a demand for providing, to users, a camera image that allows the user to easily specify the spatial relationship between the structure within the specimen chamber and the specimen unit.

JP 2014-93283 A (Document 1) discloses a scanning electron microscope having a camera that captures an image of the interior of a specimen chamber. JP 2020-126721 A (Document 2) discloses a scanning electron microscope configured to prevent collision according to computer simulation. Neither Document 1 nor Document 2 discloses display control of a camera image during an ascending process of the specimen unit. Further, neither Document 1 nor Document 2 discloses use of a camera image acquired during the ascending process of the specimen unit.

SUMMARY

The present disclosure is aimed toward enabling a user to reliably recognize a specimen unit approaching a structure during an ascending process of the specimen unit. Alternatively, the present disclosure is aimed toward enabling a user to specify a specific positional relation between a specimen unit and a structure which the specimen unit is approaching, during an ascending process of the specimen unit.

A charged particle beam apparatus according to the disclosure includes a movable stage that is disposed within a specimen chamber and is configured to support a specimen unit including a specimen and a specimen holder holding the specimen; a camera configured to take a camera image of an interior of the specimen chamber in an observation direction intersecting an optical axis direction, the camera image including a specimen unit image and an objective lens image; and a controller configured to increase a display magnification of the camera image in response to a representative height of the specimen unit having reached a magnification changing height during an ascending process for lifting the movable stage to allow the specimen unit to approach an objective lens.

A camera image displaying method in a charged particle beam apparatus, according to the disclosure, includes mounting a specimen unit on a movable stage disposed within a specimen chamber, the specimen unit including a specimen and a specimen holder holding the specimen; taking a camera image of an interior of the specimen chamber with a camera in an observation direction intersecting an optical axis direction, the camera image including a specimen unit image and an objective lens image; displaying the camera image during an ascending process for lifting the movable stage to allow the specimen unit to approach an objective lens; and during the ascending process, increasing a display magnification of the camera image in response to a representative height of the specimen unit having reached a magnification changing height.

BRIEF DESCRIPTION OF DRAWINGS

Embodiments of the present disclosure will be described based on the following figures, wherein:

FIG. 1 is a block diagram illustrating an example configuration of a scanning electron microscope according to an embodiment;
FIG. 2 illustrates an image displayed in an observation preparing stage;
FIG. 3 illustrates a method of generating a synthesized image (camera image with height guide);
FIG. 4 is a flow chart showing a camera image displaying method according to an embodiment;
FIG. 5 illustrates a synthesized image prior to a change of a display magnification;
FIG. 6 illustrates a synthesized image after a change of the display magnification;
FIG. 7 illustrates a synthesized image including a plurality of specimen images;
FIG. 8 illustrates a painted proximate zone;
FIG. 9 illustrates a protrusion amount computing method;
FIG. 10 is a flow chart showing a protrusion amount registration method;
FIG. 11 is a flow chart showing a camera image displaying method according to a modification example;
FIG. 12 illustrates a change of a synthesized image according to the modification example camera image displaying method; and
FIG. 13 illustrates an image displayed in a horizontal coordinates designating stage.

DESCRIPTION OF EMBODIMENTS

Embodiments will be described by reference to the drawings.

(1) Summary of Embodiments

A charged particle beam apparatus according to an embodiment includes a movable stage, a camera, and a controller. The movable stage is disposed within a specimen chamber. The movable stage is configured to support a specimen unit including a specimen and a specimen holder that holds the specimen. The camera takes a camera image of the interior of the specimen chamber in an observation direction orthogonal to an optical axis direction, and the camera image includes a specimen unit image and an objective lens image. The controller increases a display magnification of the camera image in response to a representative height of the specimen unit having reached a magnification changing height during an ascending process for lifting the movable stage to allow the specimen unit to approach an objective lens.

The above configuration automatically increases the display magnification of the camera image during the ascending process of the specimen unit. More specifically, the specimen unit image and the objective lens image are displayed in an enlarged manner. This change of the display magnification enables a user observing the camera image to reliably recognize that the specimen unit has approached the objective lens. This configuration further enables the user observing the enlarged camera image to specify the positional relationship between the specimen unit and a surrounding structure in detail.

The camera image is a real-time image or a live image. The representative height of the specimen unit refers to a height level that is representative of a plurality of heights of the specimen unit, and, in the embodiment, refers to a height level of a peak of the specimen. The height of the peak of the specimen normally corresponds to the height level of the highest point of the specimen unit. The height of the specimen holder may be used as the representative height, or a height that is defined by adding a standard specimen height to the height of the specimen holder may be used as the representative height. The height of the specimen holder corresponds to the height of the movable stage or is calculated from the height of the movable stage.

The magnification changing height refers to a height level that is defined to determine a certain degree of proximity or rather close proximity to the objective lens or a structure located above the specimen unit. The magnification changing height may be determined by reference to the height of the lower edge of the objective lens, for example. The magnification changing height that is to be actually used may be selected from among a plurality of magnification changing heights. In the embodiment, a proximate zone is defined in the vicinity of the lower edge of the objective lens within the real space. The lowest height of the proximate zone corresponds to the magnification changing height.

The charged particle beam apparatus according to the embodiment includes a storage unit in which the protrusion amount of the specimen from the specimen holder is registered. The representative height described above is calculated based on the current height of the specimen holder and the protrusion amount of the specimen. This configuration, in which the height of the highest point of the specimen holder corresponds to the representative height, enables reliable avoidance of a collision between the specimen unit and the structure. For example, prior to placing the specimen unit in the specimen chamber, a user measures the protrusion amount of the specimen from the specimen holder. The user thereafter inputs the protrusion amount of the specimen in the charged particle beam apparatus. As will be described below, the protrusion amount of the specimen may be measured and registered after placing the specimen unit in the specimen chamber, and more specifically, during the ascending process of the specimen unit.

In the embodiment, when the current display magnification set for the camera image is smaller than a first display magnification, the controller, in response to the representative height having reached the magnification changing height, changes the display magnification of the camera image to a second display magnification that is equal to or greater than the first display magnification. Meanwhile, when the current display magnification is greater than the first display magnification, the controller, in response to the representative height having reached the magnification changing height, maintains the current display magnification. This configuration allows execution of display in an enlarged manner when such display is necessary. The first display magnification may be the same as the second display magnification. The first display magnification and the second display magnification may be variably set individually.

The charged particle beam apparatus according to the embodiment includes a generator that generates a graphic image including a height guide to be displayed under the objective lens image. During the ascending process, a synthesized image including the camera image and the graphic image is displayed. In response to the representative height reaching the magnification changing height, the center portion of the synthesized image is displayed in an enlarged manner. This allows the specimen unit image, the objective lens image, and the height guide to be displayed in an enlarged manner. This configuration facilitates user's understanding of the extent of proximity of the specimen unit to the objective lens.

In the embodiment, the height guide includes a line indicating the magnification changing height. This configuration facilitates specific identification of the magnification changing height. This configuration further enables the user to confirm that the display magnification has been changed appropriately.

In the embodiment, the height guide includes a lower limit line or a bottom line indicating the lower boundary of the proximate zone and an upper limit line or a ceiling line indicating the upper boundary of the proximate zone. The bottom line corresponds to the line indicating the magnification changing height. This configuration facilitates specific identification of the proximate zone that is set below the objective lens. The proximate zone corresponds to a height range in which ascending of the specimen unit is allowed, but must be performed carefully. While the proximate zone is typically disposed outward of the no-entry space in the vicinity of the surface of the objective lens, the proximate zone and the no-entry space may overlap each other.

The charged particle beam apparatus according to the embodiment includes a generator and a computing unit. The generator generates a graphic image including the height guide to be displayed under the objective lens and indicating a reference height. The computing unit, which is a calculator, specifies the current height of the specimen holder at a time point when the peak of the specimen unit image reaches the line indicative of the reference height during the ascending process, and then calculates, based on the reference height and the current height of the specimen holder, the protrusion amount of the specimen from the specimen holder.

The above configuration is designed for computing the protrusion amount of the specimen based on visual judgment of the user observing the camera image. This configuration eliminates the need for measurement of the protrusion amount of the specimen performed outside the specimen chamber, thereby reducing the user's burden and also reducing the possibility of erroneous measurements or erroneous inputs.

After computation of the protrusion amount based on the camera image, control for changing the display magnification of the camera image may be performed. In this configuration, the computed protrusion amount is used for control of the display magnification to be performed subsequently. Computation of the protrusion amount based on the camera image may be performed irrespective of change of the display magnification of the camera image.

In the embodiment, the representative height of the specimen unit is calculated based on the protrusion amount of the specimen. The controller, in response to the representative height reaching the magnification changing height after computation of the protrusion amount of the specimen, increases the display magnification of the camera image.

A camera image displaying method according to an embodiment includes a mounting step, an image capturing step, a displaying step, and a controlling step. In the mounting step, a specimen unit including a specimen and a specimen holder that holds the specimen is mounted with respect to a movable stage disposed within a specimen chamber. In the image taking step, a camera takes a camera image of the interior of the specimen chamber in an observation direction orthogonal to an optical axis direction, and the camera image includes a specimen unit image and an objective lens image. In the displaying step, the camera image is displayed during an ascending process for lifting the movable stage to allow the specimen unit to approach an objective lens. In the controlling step, in response to a representative height of the specimen unit having reached a magnification changing height during the ascending process, the display magnification of the camera image is increased.

A charged particle beam apparatus according to another embodiment includes a movable stage, a camera, a generator, and a computing unit. The movable stage is disposed within a specimen chamber. The movable stage is configured to support a specimen unit including a specimen and a specimen holder holding the specimen. A camera takes a camera image of the interior of the specimen chamber in an observation direction intersecting an optical axis direction, and the camera image includes a specimen unit image and an objective lens image. The generator generates a graphic image including a height guide to be displayed below the objective lens image and indicating a reference height. The computing unit specifies the current height of the specimen holder at a time point when a peak of the specimen unit image reaches a line indicative of a reference height, during the ascending process, and then computes, based on the reference height and the current height of the specimen holder, the protrusion amount of the specimen from the specimen holder.

A camera image displaying method according to another embodiment includes a mounting step, an image taking step, a displaying step, and a computing step. In the mounting step, a specimen unit including a specimen and a specimen holder that holds the specimen is mounted with respect to a movable stage disposed within a specimen chamber. In the image taking step, a camera takes a camera image of the interior of the specimen chamber in an observation direction intersecting an optical axis direction, and the camera image includes a specimen unit image and an objective lens image. In the displaying step, the camera image is displayed during an ascending process for lifting the movable stage to allow the specimen unit to approach the objective lens. In the computing step, the current height of the specimen holder at a time point when the peak of the specimen unit image reaches a line indicative of a reference height, during the ascending process, is specified, and then, based on the reference height and the current height of the specimen holder, the protrusion amount of the specimen from the specimen holder is computed.

(2) Details of Embodiments

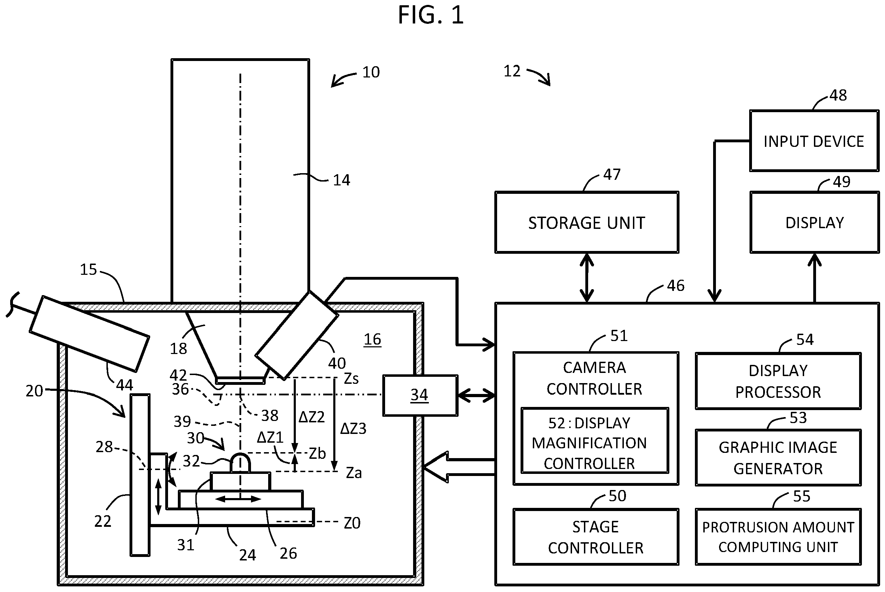

FIG. 1 illustrates a charged particle beam apparatus according to an embodiment. Specifically, the charged particle beam apparatus is a scanning electron microscope. Some of the features which will be described below may be applied to a charged particle beam apparatus other than a scanning electron microscope.

The scanning electron microscope includes a measuring unit 10 and an information processor 12. The measuring unit 10 includes a lens barrel 14 and a casing 15. The casing 15 is a housing or an enclosure. The lens barrel 14 includes a configuration to generate an electron beam and scan the electron beam two-dimensionally. Specifically, the lens barrel 14 contains an electron gun, a condensing lens, a deflection scanning coil, and an objective lens 18, for example. The interior of the casing 15 corresponds to a specimen chamber 16. The objective lens 18 has a lower end portion that protrudes into the specimen chamber 16.

The specimen chamber 16 houses a movable stage (specimen stage) 20. A specimen unit 30 including a specimen 32 and a specimen holder 31 that holds the specimen is removably mounted on the movable stage 20. In other words, the movable stage 20 supports the specimen unit 30.

More specifically, the movable stage 20 includes a plurality of mechanisms 22, 24, and 26. The movable stage 20 actually includes a Z-slide mechanism, a tilt mechanism, an X-slide mechanism, a Y-slide mechanism, and a rotation mechanism, for example. The Z-slide mechanism is designed to slide the specimen unit 30 vertically or in a height direction. The tilt mechanism is designed to tilt the specimen unit 30 about a tilt axis 28. The X-slide mechanism is designed to slide the specimen unit 30 in an X direction or a first horizontal direction (e.g., the lateral direction in FIG. 1). The Y-slide mechanism is designed to slide the specimen unit 30 in a Y direction or a second horizontal direction (e.g., a direction penetrating the sheet of FIG. 1). The rotation mechanism is designed to rotate the specimen unit 30 about a vertical axis. The specimen holder 31 to be actually used is selected from among various specimen holders, in accordance with the specimen 32. Various substances may be an observation target or the specimen 32.

In the illustrated example configuration, the specimen chamber 16 includes detectors 40, 42, and 44. The detector 40 is a secondary electron detector, for example. The detector 42 is a backscattered electron detector, for example. In the illustrated example configuration, the detector 42 is attached to a lower end face of the objective lens 18. The detector 44 is an X-ray detector, for example. Further detectors may be disposed.

The casing 15 houses a camera 34 that takes or captures an image of the interior of the specimen chamber 16. Specifically, the camera 34 is a monochrome optical camera. The camera 34 may be a color optical camera in place of a monochrome optical camera. In the illustrated example configuration, the camera 34 has a lens that is positioned within the specimen chamber 16. The camera 34 may be disposed outside a transparent window of the casing 15. The camera 34 has a field of view expanding forward. The center axis of the field of view corresponds to an observation center axis 36. The observation center axis 36 is parallel to the X direction and passes through a predetermined height point along an optical axis 39. Reference numeral 38 denotes an intersection of the observation center axis 36 and the optical axis 39. The focal point of the camera 34 is set at or near the intersection.

An illuminator, which is not shown, is disposed to illuminate the specimen unit. The center axis of a light beam emitted by the illuminator passes near the intersection 38. The illuminator is composed of one or more white LEDs, for example.

In FIG. 1, Za indicates a height level or height of the specimen holder 31, and more specifically, the height of a top surface of the specimen holder. The height Za of the specimen holder 31 corresponds to the height of the movable stage or is calculated from the height of the movable stage. Zb indicates a height level or height of the specimen 32, and specifically the height of a peak of the specimen 32. The height Zb of the specimen 32 is calculated by adding a registered protrusion amount $\Delta Z1$ of the specimen 32 to the height Za of the specimen holder 31. In the illustrated example, Z0 indicates the lowest height of the specimen holder 31, and Zs indicates the height of a lower end face of the objective lens 18.

Here, $\Delta Z2$ indicates a distance from the height Zs to the peak of the specimen 32, and $\Delta Z3$ indicates a distance from the height Zs to the specimen holder 31. The distance from the height Zs to the intersection 38 falls within a range of 2 mm to 15 mm, for example, and the distance may be 6 mm. Numerical values described in the specification of the present application are merely example values.

Example methods for measuring the protrusion amount (height of the specimen peak) $\Delta Z1$ of the specimen 32 from the specimen holder 31 include a first measuring method and a second measuring method. According to the first measuring method, the protrusion amount $\Delta Z1$ is measured manually with a measuring tool, prior to placing the specimen unit 30 within the specimen chamber 16. The measuring tool has a scale extending vertically, and the peak of the specimen 32 is compared to the scale to thereby visually specify the protrusion amount $\Delta Z1$ of the specimen 32. The user then registers a numerical value indicating the specified protrusion amount $\Delta Z1$ in the information processor 12. According to the second measuring method, the camera image described below is used to semi-automatically measure the protrusion amount $\Delta Z$ after placing the specimen unit 30 within the specimen chamber 16. The second measuring method will be described in detail below.

The information processor 12 includes a processor 46, a storage unit 47, an input device 48, and a display 49. The processor 46 is a CPU that executes a program, for example. The processor 46 controls operation of the measuring unit 10. The storage unit 47 is a memory. Specifically, the storage unit 47 is composed of a semiconductor memory or a hard disk, for example. The input device 48 is composed of a pointing device or a keyboard, for example. The user uses the input device 48 to designate coordinate values and register the heights. The display 49 is composed of an LCD or an organic EL display, for example. The display 49 displays a camera image and an SEM image, for example.

In FIG. 1, a plurality of functions to be achieved by the processor 46 are expressed by a plurality of blocks. The processor 46 functions as a stage controller 50, a camera controller 51, a graphic image generator 53, a display processor 54, and a protrusion amount computing device 55, for example. The stage controller 50 controls operation of the movable stage 20.

The camera controller 51 controls operation of the camera 34. The camera controller 51 according to the embodiment includes a display magnification controller 52. The display magnification controller 52 increases the display magnification of a camera image in response to a magnification changing condition, which can be also referred to as a proximity determining condition, being satisfied during the ascending process of the specimen unit 30. This will be described in detail below.

The graphic image generator 53 is a module that generates a graphic image to be superimposed on the camera image. The graphic image includes a height guide. In the embodiment, a height guide indicating the magnification changing height (first height guide) is generated for automatic change of the display magnification, and a height guide indicating a reference height (second height guide) is generated for measurement of the protrusion amount.

The display processor 54 synthesizes the camera image and the graphic image to thereby generate a synthesized image that is a camera image with the height guide.

The protrusion amount computing unit 55 is a module that functions at the time of performing the second measuring method. During the ascending process of the specimen unit 30, in response to the peak of the specimen image being aligned with the line indicating the reference height, the user performs registration operation. The protrusion amount computing unit 55 specifies the height Za of the specimen holder at the time of the registration operation, and computes the protrusion amount $\Delta Z1$ based on the height Za and the reference height. This process will be described in detail below.

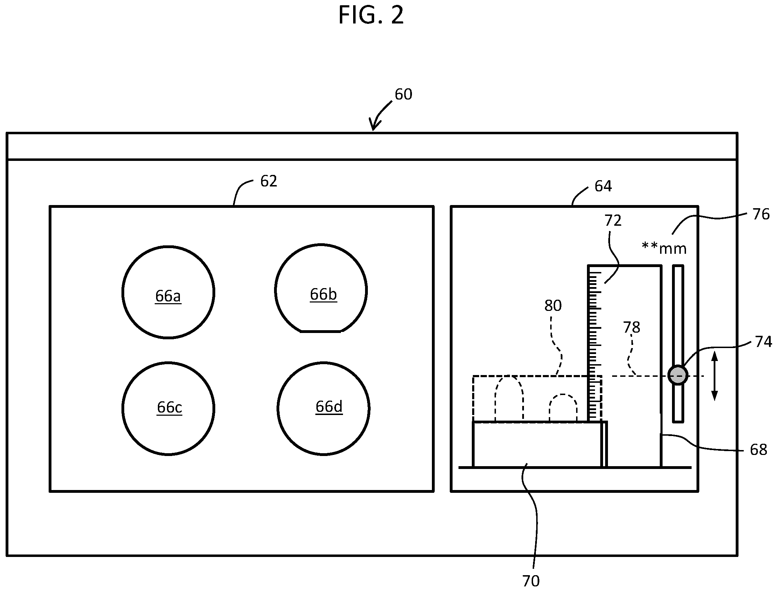

FIG. 2 illustrates an image 60 displayed in an observation preparing stage. The image 60 includes an image 62 for holder selection and an image 64 for input of the protrusion amount. The image 62 includes a plurality of holder images 66a to 66d indicating a plurality of specimen holders, respectively. The user selects a specific holder image corresponding to the specimen holder that is actually used, from among the specimen holders. This selection specifies the shape of the specimen holder that is actually used. The shape of the specimen holder may be specified based on designation of a model of the holder.

The image 64 is used for performing the first measuring method. The image 64 includes an image 68 that imitates a height measuring tool and an image 70 that imitates a holder. A holder image that represents a selected holder may be displayed as the image 70. A slider 74 is displayed adjacent to the image 68. Moving the slider 74 upward and downward enables input of the protrusion amount that is measured in advance. The input protrusion amount is displayed as a numerical value 76. Further, the input protrusion amount is registered in the storage unit in the information processor. The protrusion amount may be input in the form of numerical values.

When a single specimen is placed on the specimen holder, the protrusion amount corresponds to the height of the peak of the specimen. When two or more specimens are placed on the specimen holder, the protrusion amount corresponds to the height of the peak of the highest specimen. For collision avoidance control of the specimen unit, a virtual disk 80 having a thickness corresponding to the protrusion amount is assumed on a virtual holder. The movement of the specimen unit is restricted in response to an attempt of the disk 80 to enter the no-entry range.

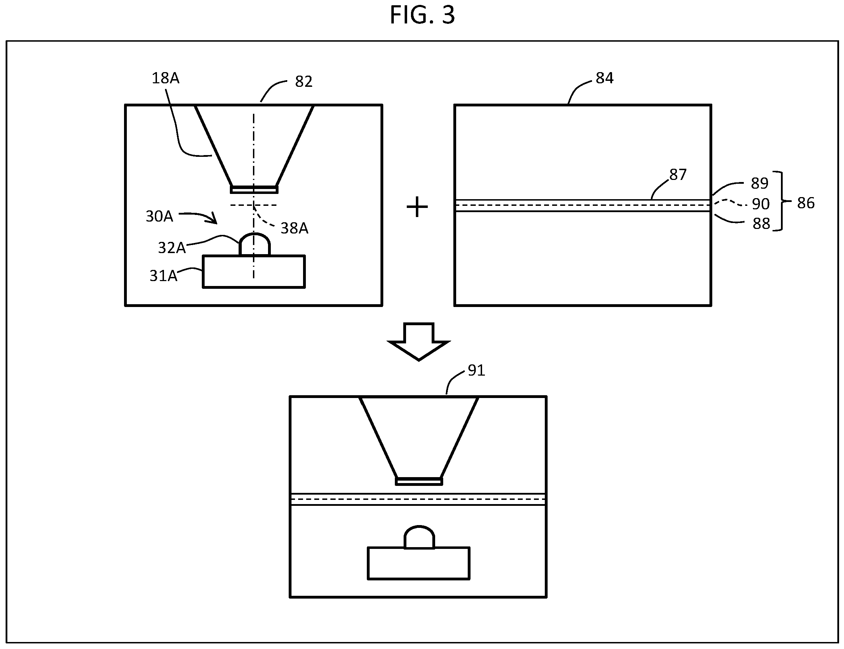

FIG. 3 shows an image processing method according to an embodiment. A camera image 82 is a real-time image that includes an objective lens image 18A and a specimen unit image 30A. The specimen unit image 30A may be displayed only partially within the camera image 82, depending on the current position and the current display magnification of the specimen unit. The specimen unit image 30A includes a specimen holder image 31A and a specimen image 32A. Reference numeral 38A denotes an intersection of the optical axis and the observation center axis. The orientation and the height of the camera are adjusted to make the center of the image correspond to the intersection 38A.

A graphic image 84 includes a height guide (first height guide) 86. The height guide 86 that is illustrated includes a line 88 indicating the lower boundary of a proximate zone 87, a line 89 indicating the upper boundary of the proximate zone 87, and further a line 90 indicating an intermediate height between the lower boundary and the upper boundary. In the embodiment, the lower boundary of the proximate zone 87 corresponds to the magnification changing height. Thus, the line 88 corresponds to a line indicating the magnification changing height. The distance from the lower face level of the objective lens to the magnification changing height may be within a range of 2 mm to 15 mm, for example. In the embodiment, the distance is 7 mm, for example. While the proximate zone 87 has a flat plate shape having a fixed thickness, the proximate zone 87 may be a planar zone.

The camera image 82 and the graphic image 84 are synthesized to form a synthesized image 91. In a movable stage moving process, especially the ascending process, prior to the specimen observation, the synthesized image 91 is displayed.

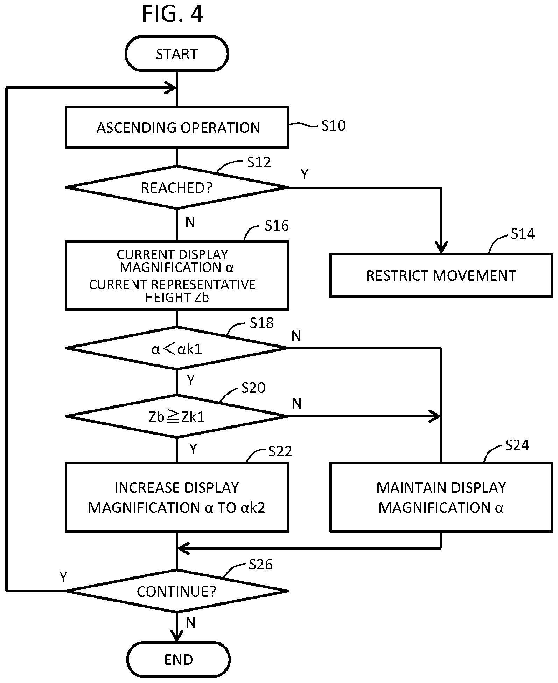

FIG. 4 shows a camera image displaying method according to an embodiment. Typically, prior to the specimen observation, the horizontal position of the specimen unit is determined, and thereafter, the vertical position (height) of the specimen unit is determined. In other words, after the horizontal movement of the specimen unit, the ascending process of the specimen unit is performed. The camera image displaying method according to the embodiment is performed during the ascending process, and more particularly, is performed in lifting the specimen unit to the vicinity of the objective lens.

In step S10, the specimen unit lifting operation by a user is accepted. This operation allows an increase in the height of the specimen unit. In step S12, a determination is made as to whether or not the specimen unit (more specifically, the specimen unit including the disk described above) has reached a no-entry space. The no-entry space is a space determined along a structure surface within the specimen chamber. Other collision avoiding means may be employed.

In response to the specimen unit having reached the no-entry space, in step S14, movement, or ascending, of the specimen unit is restricted. In response to the specimen unit having not reached the no-entry space, the process in step S16 is performed.

In step S16, the current display magnification $\alpha$ is specified for a camera image, and the current representative height is specified for the specimen unit. In the embodiment, the representative height refers to a height that is representative of the specimen unit, and is more specifically a height $Zb$ of the peak of a specimen. The height $Zb$ is calculated by adding, to a height $Za$ of the specimen holder, a registered protrusion amount $\Delta Z1$. The height $Za$ of the specimen holder corresponds to the height of the movable stage, or is specified from the height of the movable stage. The user may change the display magnification $\alpha$ at any timing.

In step S18, a determination is made as to whether the current display magnification $\alpha$ is smaller than the first display magnification $\alpha k1$. In response to determination that the current display magnification $\alpha$ is smaller than the first display magnification $\alpha k1$, the process in step S20 is performed, whereas in response to determination that the display magnification $\alpha$ is equal to or greater than the first display magnification $\alpha k1$, the process in step S24 is performed.

In step S20, a determination is made as to whether the current representative height $Zb$ has reached the magnification changing height $Zk1$. In response to determination that the current representative height $Zb$ has not reached the magnification changing height $Zk1$, the process in step S24 is performed. In response to determination that the representative height $Zb$ has reached the magnification changing height $Zk1$, the process in step S22 is performed.

In step S24, the display magnification $\alpha$ is maintained. In step S22, the display magnification $\alpha$ is increased to a second display magnification $\alpha k2$. In the embodiment, the second display magnification $\alpha k2$ is equal to the first display magnification $\alpha k1$. The second display magnification $\alpha k2$ may be selected from within range of 1.5 to 8. In step S26, a determination is made as to whether to continue the movement or ascending of the specimen unit. In response to the determination to continue ascending, the processes in step S10 and the subsequent steps are performed once again.

The camera image displaying method according to the embodiment is designed for automatically increasing the display magnification of the camera image in response to the height representative of the specimen unit reaching a predetermined height. This method enables the user to reliably recognize the proximity state through a change of the display magnification. This method further enables the user to carefully perform the lifting operation of the specimen unit while observing the camera image displayed in an enlarged manner and the height guide, for example.

The camera image that is already enlarged would not be further enlarged. This configuration prevents excessive enlargement of the camera image. The first display magnification and the second display magnification may be variably set by the user.

The tilt angle, which is not considered in the above embodiment, may be considered during the above control process. Specifically, the height of the highest point of the specimen unit after the tilting movement may be determined as the representative height of the specimen unit.

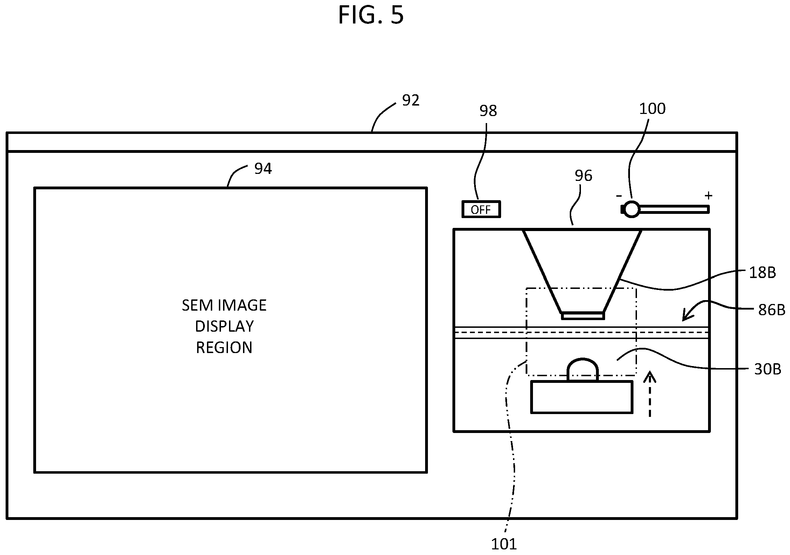

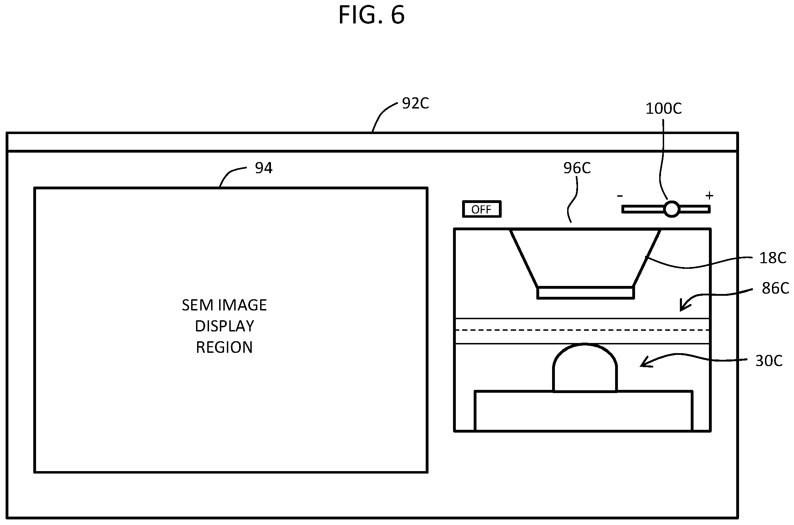

FIG. 5 and FIG. 6 illustrate images displayed during the ascending process of the specimen unit. In FIG. 5, an image 92 includes an SEM image display region 94, and a synthesized image 96 prior to an increase in the display magnification. The synthesized image 96 includes an objective lens image 18B and a specimen unit image 30B. The synthesized image 96 further includes a height guide 86B. A button 98 is used for switching between on and off of display of the height guide 86B. A slider 100 is used for manually changing the display magnification of the synthesized image. Reference numeral 101 indicates a center part to be enlarged. In an embodiment, the center of this center part corresponds to the intersection of the optical axis and the observation center axis. In other words, the center of the center part is located on the center line of the height guide.

FIG. 6 illustrates an image 92C including a synthesized image 96C immediately after the increase in the display magnification. Specifically, an objective lens image 18C, a specimen unit image 30C, and a height guide 86C are displayed in an enlarged manner. The specimen unit image 30C shows a specimen peak in contact with the bottom line of the height guide 86C. A slider 100C has been moved to a position corresponding to the changed display magnification.

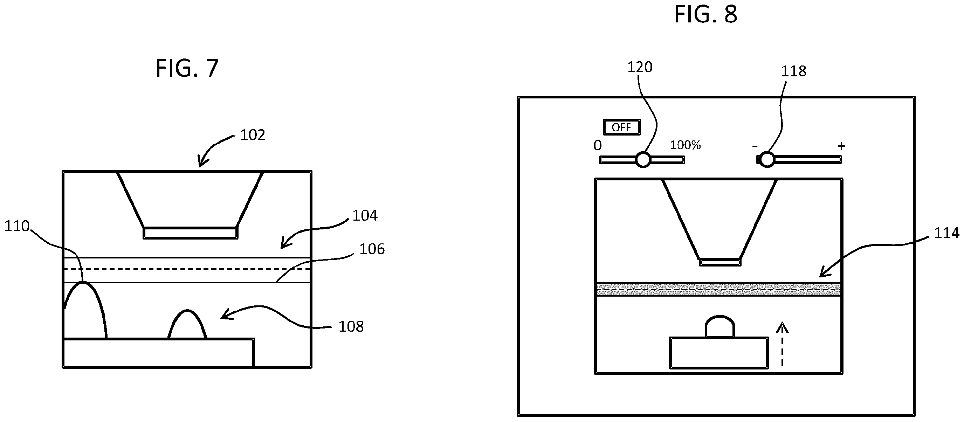

FIG. 7 illustrates a synthesized image 102 after the increase in the display magnification. The specimen unit image includes a plurality of specimen images, of which the highest specimen image has a peak 110 that has reached a bottom line 106 of a height guide 104. In this embodiment, the line indicating the magnification changing height, or the bottom line 106, extends across the entire synthesized image. This enables the user to easily confirm that the magnification changing condition is satisfied even when the highest specimen image is not located on the optical axis.

As illustrated in FIG. 8, the interior of a height guide 114 may be filled with a predetermined color. In this configuration, in addition to a display magnification changing slider 118, a transparency changing slider 120 is displayed. The slider 120 is operated to change transparency of the color of the height guide 114.

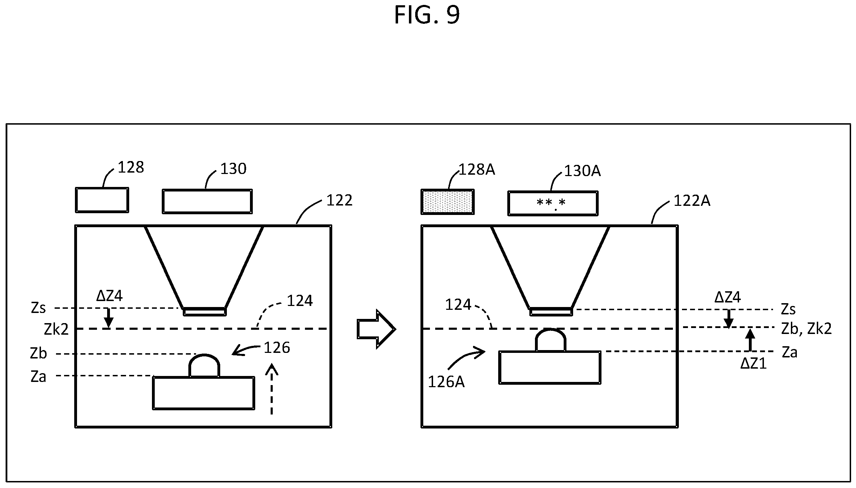

With reference to FIG. 9 to FIG. 12, a second measuring method of the protrusion amount will be described. According to the second measuring method, the user, while referring to a camera image, indirectly designates the protrusion amount during the ascending process of the specimen unit. In performing the second measuring method, the tilting movement of the specimen unit is prohibited; therefore, the tilt angle is set to 0 degrees.

FIG. 9 illustrates two synthesized images 122 and 122A acquired stepwise during the ascending process of the specimen unit. The synthesized image 122 on the left includes a specimen unit image 126 and a height guide (second height guide) 124. The height guide 124 corresponds to a line indicating a reference height $Zk2$.

The reference height $Zk2$ is lower than the height $Zs$ of the lower end face of the objective lens by a distance $\Delta Z4$. A height $Za$ is a height of the specimen holder and is known. A height $Zb$ is a height of a peak of the specimen. Since the protrusion amount of the specimen is not known, the height $Zb$ is not also known. A button 128 is used for registration operation. A display box 130 shows the protrusion amount that is computed, as a numerical value.

After ascending of the specimen unit, the synthesized image 122A on the right shows a peak of the specimen unit image 126A having reached the height guide 124. At this point in time, the user operates a button 128A, and the height $Za$ of the specimen holder at this time point of operation is specified. Then, the protrusion amount $\Delta Z1$ of the specimen is computed based on the height $Za$ of the specimen holder, the height $Zs$ of the lower end face, and the distance $\Delta Z4$ described above, as follows:

$$\Delta Z1 = Zb - Za = (Zs - \Delta Z4) - Za \quad \cdot \cdot \cdot (1)$$

In the above equation (1), $(Zs - \Delta Z4)$ corresponds to $Zk2$. A display box 130A indicates the computed protrusion amount $\Delta Z1$. The protrusion amount $\Delta Z1$ is to be stored in the storage unit.

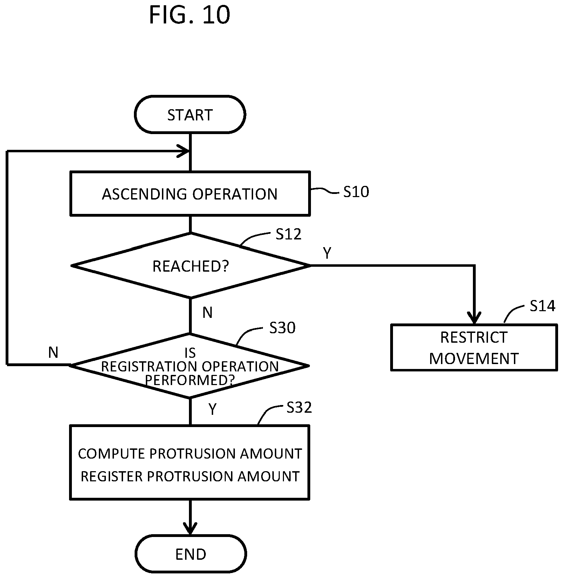

FIG. 10 shows the second measuring method in a flow chart. After adjusting the horizontal coordinates of the specimen unit, operation to lift the specimen unit is accepted in step S10. The processes in step S12 and step S14 are already described above (see FIG. 4). In step S30, the user determines, based on the synthesized image, whether the specimen peak has reached the height guide. In response to determination that the specimen peak has not reached the height guide, the processes in step S10 and the subsequent steps are repeated. In response to the determination that the specimen peak has reached the height guide and the subsequent user's registration operation in S30, the protrusion amount is computed and registered in the storage unit according to the above equation (1) in step S32.

After execution of the process in step S32, the specimen unit is transferred to the observation position as required. Prior to this process, the specimen unit may be temporarily withdrawn.

The protrusion amount registered in the storage unit may be used for control of display magnification change. More specifically, after execution of a series of processes shown in FIG. 10, the series of processes shown in FIG. 4 may be performed. In this case, the height of the specimen peak is specified based on the protrusion amount that is registered as described above. The registered protrusion amount may be used for collision avoidance control, focus control of electron beam, and other controls.

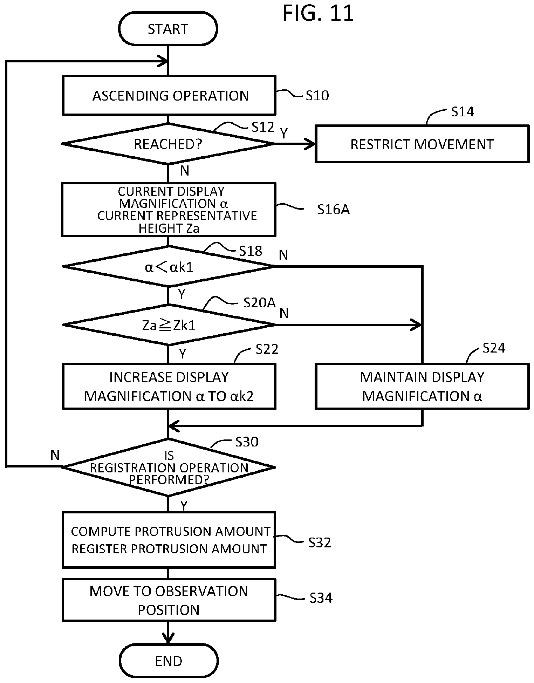

FIG. 11 shows a method according to a modification example. In FIG. 11, the processes that are the same as those in FIG. 4 and FIG. 10 are denoted with the same step numbers and their descriptions will not be repeated.

After execution of the processes in step S10 and step S12, the current display magnification $\alpha$ is specified and the current representative height is also specified in step S16A. In the example shown in FIG. 11, the representative height corresponds to the height Za of the specimen holder. The representative height may be a height calculated by adding, to the height Za, a reference specimen height or a margin.

In response to determination that the current display magnification is smaller than the first display magnification in step S18 and determination that the representative height Za corresponds to the magnification changing height Zk1 in step S20A, in step S22, the display magnification $\alpha$ is changed to the second display magnification $\alpha2$. Thus, the synthesized image is displayed in an enlarged manner.

In response to the user's determination, based on the displayed enlarged synthesized image, that the peak of the specimen image has reached the reference height, the user performs registration operation in step S30. Thus, in step S32, the protrusion amount is computed and registered. In step S34, the specimen unit is further moved as required.

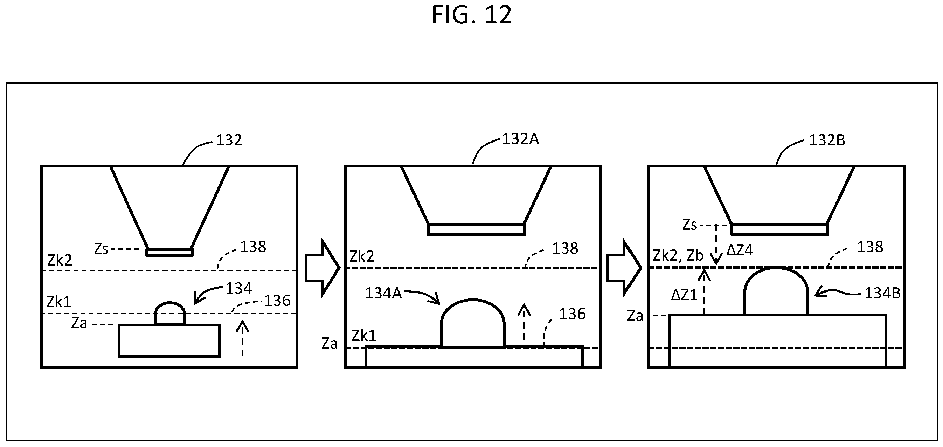

FIG. 12 illustrates transition of the specimen image in the modification example. A synthesized image 132 illustrates a state before the height Za of the specimen holder reaches the magnification changing height Zk1. The synthesized image 132 includes a specimen unit image 134, a first height guide 136, and a second height guide 138. The first height guide 136 is composed of a horizontal line indicating the magnification changing height Zk1. The second height guide 138 is composed of a horizontal line indicating the reference height Zk2.

A synthesized image 132A is displayed when the height Za of the specimen holder is aligned with the magnification changing height Zk1. The top face of the specimen holder in a specimen unit image 134A is aligned with the first height guide 136. The specimen unit image 134A and the second height guide 138 are disposed with a fixed space therebetween.

A synthesized image 132B is displayed in response to the specimen peak in a specimen unit image 134B reaching the second height guide 138. Actually, the user's registration operation is accepted at this time. As described above, based on the height Za of the specimen holder at this time, the height Zs, and the distance $\Delta Z4$, the protrusion amount $\Delta Z1$ is computed.

The above modification example enables the user to determine that the specimen peak has reached the reference height while viewing the enlarged synthesized image after an increase in the display magnification. In the modification example, the first height guide is positioned a predetermined distance apart from the second height guide. For example, the maximum value $\Delta max$ of the protrusion amount in performing the modification example is determined, and based on the relation of $\Delta k1 = \Delta k2 - (\Delta max + \beta)$, the magnification changing height $\Delta k1$ or the reference height $\Delta k2$ may be determined. Here, $\beta$ corresponds to a margin.

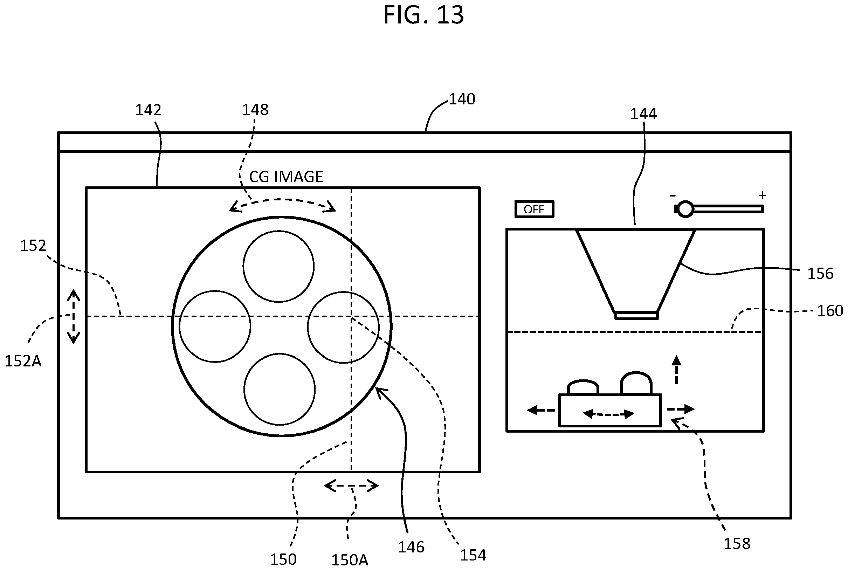

FIG. 13 illustrates an image 140 that is displayed prior to execution of the ascending process. The image 140 includes a region 142 including a CG image 146 imitating a holder to be used. In place of the CG image 146, a holder image that is actually captured may be displayed. The image 140 further includes a synthesized image 144.

The user performs rotation operation to rotate the CG image 146 (see reference numeral 148). Two cursors 150 and 152 are displayed on the CG image 146. The cursors 150 and 152 are moved (see reference numerals 150A and 152A) to designate an intersection that is an observation coordinate 154 on the horizontal plane. In association with the rotation operation and the designation of the horizontal coordinates described above, the movable stage is actually moved. Specifically, the movable stage is horizontally moved to align the observation coordinate 154 on the optical axis.

The synthesized image 144 includes an objective lens image 156, a specimen unit image 158, and a height guide 160. The height guide 160 corresponds to a horizontal line indicating the magnification changing height. The specimen unit image 158 reflects the movement of the movable stage as described above. It is therefore possible to confirm the position of the movable stage, for example, through observation of the synthesized image 144. After setting the observation coordinates on the horizontal plan, the height of the specimen unit is changed. Thus, the ascending process described above is performed. In response to the representative height of the specimen unit being aligned with the magnification changing height, the display magnification of the synthesized image is increased.

Here, display of the camera image may be started in response to the representative height of the specimen unit reaching a predetermined height during the ascending process. In this case, the camera image may be displayed with a predetermined display magnification. Appearance of the camera image enables the user to reliably recognize that the specimen unit has reached the predetermined height.

According to the above embodiment, it is possible for the user to reliably recognize the specimen unit having approached the objective lens during the ascending process of the specimen unit. It is also possible for the user to specifically identify the positional relation between the specimen unit and the structure located in the vicinity during the ascending process of the specimen unit. Further, the second measuring method described above eliminates the need to measure the protrusion amount of the specimen outside the specimen chamber, thereby reducing the user's burden or reducing possible occurrence of erroneous measurements and erroneous inputs.

**Claims**

1. A charged particle beam apparatus comprising:

   a movable stage (20) that is disposed within a specimen chamber (16) and is configured to support a specimen unit (30) including a specimen and a specimen holder holding the specimen;
   a camera (34) configured to take a camera image of an interior of the specimen chamber (16) in an observation direction intersecting an optical axis direction, the camera image including a specimen unit image and an objective lens image; and
   a controller (52) configured to increase a display magnification of the camera image in response to a representative height of the specimen unit (30) having reached a magnification changing height during an ascending process for lifting the movable stage (20) to allow the specimen unit (30) to approach an objective lens.

2. The charged particle beam apparatus according to claim 1, further comprising:

   a storage unit (47) in which a protrusion amount of the specimen from the specimen holder is registered, wherein
   the representative height is calculated based on a current height of the specimen holder and the protrusion amount of the specimen.

3. The charged particle beam apparatus according to claim 1, wherein
   the controller (52) is configured to:

   in response to the representative height having reached the magnification changing height when a current display magnification of the camera image is smaller than a first display magnification, change the display magnification of the camera image to a second display magnification that is equal to or greater than the first display magnification; and
   in response to the representative height having reached the magnification changing height when the current display magnification is greater than the first display magnification, maintain the current display magnification.

4. The charged particle beam apparatus according to claim 1, further comprising:

   a generator (53) configured to generate a graphic image including a height guide displayed under the objective lens image, wherein
   during the ascending process, a synthesized image comprising the camera image and the graphic image is displayed, and
   in response to the representative height having reached the magnification changing height, a center portion of the synthesized image is displayed in an enlarged manner, to thereby display the specimen unit image, the objective lens image, and the height guide in an enlarged manner.

5. The charged particle beam apparatus according to claim 4, wherein
   the height guide includes a line indicating the magnification changing height.

6. The charged particle beam apparatus according to claim 5, wherein

   the height guide includes a bottom line indicating a lower boundary of a proximate zone and a ceiling line indicating an upper boundary of the proximate zone, and
   the bottom line corresponds to a line indicating the magnification changing height.

7. The charged particle beam apparatus according to claim 1, further comprising:

   a generator (53) configured to generate a graphic image including a height guide displayed under the objective lens image, the height guide including a line indicating a reference height; and

a computing unit (55) configured to specify a current height of the specimen holder in response to a peak of the specimen unit being aligned with the line indicating the reference height during the ascending process, and, based on the reference height and the current height of the specimen holder, compute a protrusion amount of the specimen from the specimen holder.

8. The charged particle beam apparatus according to claim 7, wherein

the representative height of the specimen unit (30) is calculated based on the protrusion amount of the specimen, and
the controller (52) is configured to increase the display magnification of the camera image in response to the representative height having reached the magnification changing height, after computation of the protrusion amount of the specimen.

9. A camera image displaying method in a charged particle beam apparatus, the method comprising:

mounting a specimen unit (30) on a movable stage (20) disposed within a specimen chamber (16), the specimen unit (30) comprising a specimen and a specimen holder holding the specimen;
taking a camera image of an interior of the specimen chamber (16) with a camera (34) in an observation direction intersecting an optical axis direction, the camera image including a specimen unit image and an objective lens image;
displaying the camera image during an ascending process for lifting the movable stage (20) to allow the specimen unit (30) to approach an objective lens; and
during the ascending process, increasing a display magnification of the camera image in response to a representative height of the specimen unit (30) having reached a magnification changing height.

EP 4 521 445 A2

# FIG. 1

FIG. 2

FIG. 3

EP 4 521 445 A2

FIG. 4

```
                    ┌──────────┐
                    │  START   │
                    └──────────┘
                         │
    ┌────────────────────┤
    │         ┌───────────────────────┐
    │         │  ASCENDING OPERATION  │──── S10
    │         └───────────────────────┘
    │                    │
    │              ╱────────────╲  ── S12      Y
    │             ╱   REACHED?    ╲─────────────────────┐
    │             ╲              ╱                       │
    │              ╲────────────╱                        ▼
    │                    │ N                   ┌──────────────────┐
    │         ┌───────────────────────┐        │                  │ ── S14
    │         │  CURRENT DISPLAY      │── S16   │ RESTRICT MOVEMENT│
    │         │  MAGNIFICATION α      │        │                  │
    │         │  CURRENT REPRESENTATIVE│       └──────────────────┘
    │         │  HEIGHT Zb            │
    │         └───────────────────────┘
    │                    │
    │              ╱────────────╲ ── S18     N
    │             ╱   α < αk1     ╲──────────────────────────────┐
    │             ╲              ╱                                │
    │              ╲────────────╱                                 │
    │                    │ Y                                      │
    │              ╱────────────╲ ── S20   N                      │
    │             ╱   Zb ≧ Zk1    ╲──────────────────┐            │
    │             ╲              ╱                    │            │
    │              ╲────────────╱                     │            │
    │                    │ Y                          ▼            │
    │         ┌───────────────────┐        ┌───────────────────┐  │
    │         │ INCREASE DISPLAY  │── S22  │ MAINTAIN DISPLAY  │──│ S24
    │         │ MAGNIFICATION α   │        │ MAGNIFICATION α   │  │
    │         │ TO αk2            │        │                   │  │
    │         └───────────────────┘        └───────────────────┘  │
    │                    │                          │             │
    │                    ◄──────────────────────────┴─────────────┘
    │              ╱────────────╲ ── S26
    │    Y        ╱  CONTINUE?    ╲
    └────────────╲              ╱
                  ╲────────────╱
                        │ N
                    ┌──────────┐
                    │   END    │
                    └──────────┘
```

SEM IMAGE
DISPLAY
REGION

94

92

FIG. 5

OFF

98

96

100

101

30B

86B

18B

FIG. 6

SEM IMAGE
DISPLAY
REGION

94

92C

96C

100C

OFF

30C

86C

18C

FIG. 7

FIG. 8

FIG. 9

# FIG. 10

START

ASCENDING OPERATION — S10

REACHED? — S12
- N
- Y → RESTRICT MOVEMENT — S14

IS REGISTRATION OPERATION PERFORMED? — S30
- N
- Y

COMPUTE PROTRUSION AMOUNT
REGISTER PROTRUSION AMOUNT — S32

END

FIG. 11

START

ASCENDING OPERATION ~S10

REACHED? ~S12
N / Y

Y → RESTRICT MOVEMENT ~S14

N

CURRENT DISPLAY MAGNIFICATION α
CURRENT REPRESENTATIVE HEIGHT Za ~S16A

α < αk1 ~S18
Y / N

Za ≧ Zk1 ~S20A
Y / N

N → MAINTAIN DISPLAY MAGNIFICATION α ~S24

Y → INCREASE DISPLAY MAGNIFICATION α TO αk2 ~S22

IS REGISTRATION OPERATION PERFORMED? ~S30
N / Y

COMPUTE PROTRUSION AMOUNT
REGISTER PROTRUSION AMOUNT ~S32

MOVE TO OBSERVATION POSITION ~S34

END

FIG. 12

FIG. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014093283 A

- JP 2020126721 A